# FASCICULE DE BREVET EUROPEEN

(11) **EP 3 961 349 B1**
(45) Date de publication et mention de la délivrance du brevet: **01.05.2024**
(21) Numéro de dépôt: 21192823.9
(22) Date de dépôt: 24.08.2021
(51) Int. Cl.: G06F 1/24, G06F 1/3206

(54) **CIRCUIT INTÉGRÉ, PROCÉDÉ DE RÉINITIALISATION ET PRODUIT PROGRAMME D'ORDINATEUR**
INTEGRIERTER SCHALTKREIS, RESET-VERFAHREN UND COMPUTERPROGRAMMPRODUKT
INTEGRATED CIRCUIT, RESET METHOD AND COMPUTER PROGRAM PRODUCT

(30) Priorité: 27.08.2020 FR 2008759
(43) Date de publication de la demande: 02.03.2022
(73) Titulaire: STMicroelectronics (Rousset) SAS, 13790 Rousset (FR)
(72) Inventeur: CASSAGNES, Herve, 13300 SALON-DE-PROVENCE (FR); MOULIN, Cyril, 13100 AIX-EN-PROVENCE (FR); GRIL-MAFFRE, Jean-Michel, 13090 AIX-EN-PROVENCE (FR)
(74) Mandataire: Cabinet Beaumont

(56) Documents cités:
- EP-A1- 3 171 244
- US-A- 5 109 506

## Description

### DOMAINE DE L'INVENTION

La présente invention concerne, de manière générale, les circuits intégrés comprenant plusieurs parties dont certaines de ces parties peuvent être placées sélectivement dans un mode de fonctionnement de type veille (ci-après mode de fonctionnement veille) ou dans un mode de fonctionnement de type actif (ci-après mode de fonctionnement actif).

### ETAT DE LA TECHNIQUE

Un circuit intégré, aussi appelé puce électronique, est un composant électronique, comprenant une plaque unique de matériau semi-conducteur. Le circuit intégré est habituellement configuré pour mettre en oeuvre plusieurs fonctions et comprend généralement, à ce titre, plusieurs types de composants électroniques de base.

Le circuit intégré se présente généralement sous la forme d'un boîtier plein, rectangulaire, équipé sur un ou plusieurs côtés, voire sur une face, de pattes (appelées aussi broches ou « pins » en anglais) permettant d'établir des connexions électriques avec des éléments extérieurs au boitier.

Une partie du circuit intégré peut être placée sélectivement dans un mode de fonctionnement actif ou un mode de fonctionnement veille. Le mode de fonctionnement veille est aussi connu sous l'expression mode de fonctionnement basse consommation (« low power mode » en anglais). Dans le mode de fonctionnement veille la tension d'alimentation de la partie du circuit intégré est donc baissée par rapport à la tension d'alimentation utilisée lorsque la partie du circuit intégré est en mode de fonctionnement actif. Le document EP 3171244 A1 décrit une mise en veille d'un circuit électronique.

Une première tension d'alimentation est généralement fixée pour être suffisante pour conserver des informations enregistrées dans une mémoire présente dans la partie de circuit intégré alimentée par cette tension. Cette première tension d'alimentation est également suffisante pour permettre la réinitialisation (ou « reset » en anglais) de la partie de circuit intégré alimentée par cette tension. Le document US 5109506 A décrit un exemple d'un système comprenant un circuit de réinitialisation.

De manière alternative, on peut aussi utiliser une deuxième tension d'alimentation inférieure à la première tension qui est aussi suffisante pour conserver les informations enregistrées dans la mémoire présente dans la partie du circuit intégré alimentée par cette tension.

Cependant cette deuxième tension peut s'avérer insuffisante pour permettre la réinitialisation de la partie du circuit intégré alimentée par cette tension.

Dès lors, un problème intervient quand une partie du circuit intégré reçoit un signal de réinitialisation, si cette partie du circuit intégré est alimentée par une tension comprise entre la première tension et la deuxième tension (par exemple comprise entre 0,66V et 0,9V), en effet dans ce cas la partie du circuit intégré n'est pas réinitialisée.

Il existe donc un besoin d'avoir un circuit intégré permettant la réinitialisation d'une partie du circuit intégré lorsque cette partie est alimentée par une tension normalement insuffisante pour la réinitialisation par exemple comprise entre 0,66V et 0,9V.

### EXPOSE DE L'INVENTION

L'invention permet de pallier les inconvénients précités en proposant un circuit intégré. Le circuit intégré comprend une première partie et une deuxième partie. La première partie comprend une entrée de réinitialisation configurée pour recevoir un signal de réinitialisation, un module d'activation relié à l'entrée de réinitialisation. Le module d'activation est configuré pour activer la deuxième partie à la réception du signal de réinitialisation. La première partie comprend un module d'émission configuré pour émettre un signal de réinitialisation répliqué. La deuxième partie peut être sélectivement activée ou désactivée. La deuxième partie comprend une entrée de réinitialisation configurée pour recevoir le signal de réinitialisation répliqué du module d'émission, un module de détermination configuré pour déterminer qu'un temps écoulé à partir de l'activation de la deuxième partie du circuit dépasse un seuil. Le circuit intégré est tel que le module d'émission est configuré pour émettre le signal de réinitialisation répliqué à la réception du signal de réinitialisation, le module d'émission est configuré pour arrêter l'émission du signal de réinitialisation répliqué lorsque le seuil est dépassé.

Le circuit intégré, selon un premier aspect de l'invention permet la réinitialisation de la deuxième partie, même si le signal de réinitialisation a été reçu durant une période où la deuxième partie est en veille. En effet, suite à la réception d'un signal réinitialisation, la première partie active la deuxième partie. Suite à cette activation la première partie émet un signal de réinitialisation répliqué. Cette émission est réalisée suffisamment longtemps pour que la deuxième partie ait pu être activée et soit dans un état permettant sa réinitialisation au moment de l'émission du signal de réinitialisation répliqué.

Dans un mode de réalisation le module d'émission comprend une bascule. La bascule est configurée pour être sélectivement dans un état stocké ou dans un état effacé. La bascule comprend une entrée d'horloge, reliée à l'entrée de réinitialisation de la première partie, une entrée de données recevant un signal actif, une entrée d'effacement, reliée à une sortie du module de détermination. Le module de détermination est configuré pour émettre sur sa sortie un signal de dépassement lorsque le seuil est dépassé. La bascule est configurée pour passer dans l'état stocké, à la réception d'un front du signal du réinitialisation, une sortie de la bascule est configurée pour émettre un signal d'état actif lorsque la bascule est dans l'état stockée. La bascule est configurée pour passer dans l'état effacé, lorsque le signal de dépassement est actif. La sortie de la bascule est configurée pour émettre un signal d'état inactif lorsque la bascule est dans l'état effacé.

Dans un mode de réalisation le module d'émission comprend une porte logique. La porte logique comprend une première entrée configurée pour recevoir le signal d'état de la sortie de la bascule, une deuxième entrée configurée pour recevoir le signal de réinitialisation, une sortie reliée à la sortie du module d'émission et configurée pour émettre le signal de réinitialisation répliqué. La porte logique est configurée pour que le signal de réinitialisation répliqué soit actif si le signal d'état est actif ou si le signal de réinitialisation est actif.

Dans un mode de réalisation la deuxième partie comprend une horloge configurée pour émettre un signal d'horloge lorsque la deuxième partie est active. Le module de détermination comprend une première bascule et une deuxième bascule. La première bascule comprend une entrée d'horloge configurée pour recevoir le signal d'horloge, une entrée de données configurée pour recevoir un signal inactif, une sortie configurée pour émettre un signal de sortie intermédiaire. La première bascule est configurée pour que, suite à un premier front du signal d'horloge, le signal de sortie intermédiaire passe dans un état actif. La deuxième bascule comprend une entrée d'horloge configurée pour recevoir le signal d'horloge, une entrée de données reliée à la sortie de la première bascule, une sortie, reliée à la sortie du module de détermination et configurée pour émettre le signal de dépassement. La deuxième bascule est configurée pour que, suite à un deuxième front du signal d'horloge postérieur au premier front, le signal de dépassement passe dans un état actif.

Dans un mode de réalisation le circuit intégré comprend une première porte logique comprenant une entrée reliée à la sortie du module d'émission de la première partie, une sortie reliée à l'entrée de réinitialisation de la deuxième partie, une entrée de commande reliée à une sortie d'isolation du module d'activation. Le circuit intégré comprend une deuxième porte logique comprenant une entrée reliée à la sortie de dépassement du module de détermination, une sortie reliée à une entrée de dépassement du module d'émission de la première partie, une entrée de commande reliée à la sortie d'isolation du module d'activation. Le module d'activation est configuré pour émettre un signal d'isolation sur sa sortie d'isolation. La première porte logique est configurée pour être passante à la réception du signal d'isolation sur son entrée de commande. La deuxième porte logique est configurée pour être passante à la réception d'un signal d'isolation sur son entrée de commande.

Selon un autre aspect un procédé de réinitialisation d'une deuxième partie d'un circuit intégré par une première partie d'un circuit intégré est proposé. Le procédé comprend les étapes suivantes :
- réception d'un signal de réinitialisation par la première partie (PART1),
- activation de la deuxième partie,
- émission d'un signal de réinitialisation répliqué par la première partie vers la deuxième partie,
- détermination qu'un temps écoulé depuis l'activation de la deuxième partie a dépassé un seuil,
- arrêt de l'émission du signal de réinitialisation répliqué lorsque le temps écoulé depuis l'activation de la deuxième partie a dépassé le seuil.

Dans un mode de réalisation le procédé de réinitialisation comprend en outre une étape de connexion électrique entre la première partie et la deuxième partie. L'étape de connexion est réalisée entre l'étape d'activation et l'étape d'émission.

Selon un autre aspect un produit programme d'ordinateur est proposé. Ce produit programme d'ordinateur comprend des instructions de code de programme qui, lorsqu'elles sont exécutées par un circuit intégré (CINT), permettent la mise en oeuvre du procédé de réinitialisation décrit ci-dessus.

### DESCRIPTION DES FIGURES

D'autres caractéristiques, buts et avantages de l'invention ressortiront de la description qui suit, qui est purement illustrative et non limitative et qui doit être lue en regard des dessins annexés sur lesquels :
La figure 1 représente de façon schématique un circuit intégré selon un mode de réalisation de l'invention.
La figure 2 représente de façon schématique un circuit intégré selon un autre mode de réalisation de l'invention.
La figure 3 représente un diagramme temporel des différents signaux échangés entre les différents éléments du circuit intégré selon un mode de réalisation de l'invention.
La figure 4 représente un procédé de réinitialisation selon un mode de réalisation de l'invention.

### DESCRIPTION DETAILLEE DE L'INVENTION

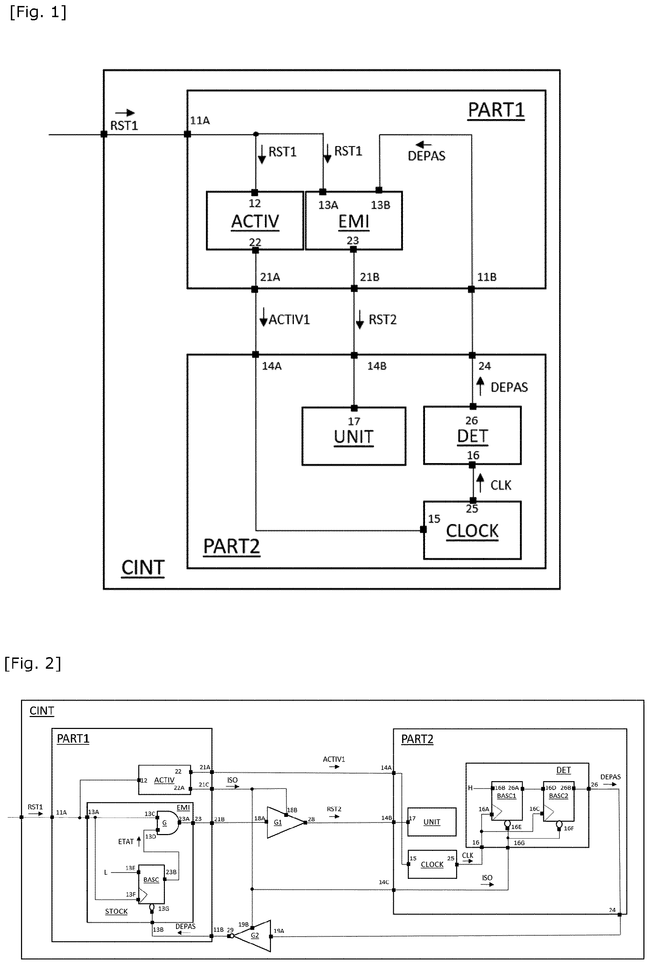

La figure 1 représente de façon schématique un circuit intégré CINT selon un mode de réalisation de l'invention.

On précise que sur les figures les carrés pleins représentent une entrée ou une sortie et les disques pleins représentent une connexion électrique entre deux fils.

Dans ce qui suit les entrées sont indiquées par une référence commençant par le chiffre 1 et les sorties par une référence commençant par le chiffre 2.

Le circuit intégré CINT comprend une première partie PART1 et une deuxième partie PART2.

La deuxième partie PART2 peut présenter sélectivement deux modes de fonctionnement :
- Un mode de fonctionnement actif, et
- Un mode de fonctionnement veille.

Une tension d'alimentation de la deuxième partie PART2, lorsqu'elle est en veille, est généralement de 0,6V. La tension d'alimentation de la deuxième partie PART2, lorsqu'elle est active, est généralement de 0,9V.

La tension d'alimentation de la première partie PART1, lorsqu'elle est en veille, est généralement de 3,0V.

On dit que la deuxième partie PART2 est activée lorsque l'on modifie sa tension d'alimentation pour la faire passer de la tension en fonctionnement veille à la tension en fonctionnement actif.

La première partie PART1 et la deuxième partie PART2 comprennent chacune plusieurs modules. Ces modules échangent entre eux des signaux logiques. Chaque signal logique est représenté par un signal électrique pouvant prendre deux niveaux, un niveau haut (en anglais "high" = "H") et un niveau bas (en anglais "low" = "L"). La tension du niveau haut est supérieure à la tension du niveau bas. On appelle front montant le passage du signal électrique du niveau bas au niveau haut. On appelle front descendant le passage du signal électrique du niveau haut au niveau bas.

On définit un niveau actif comme étant le niveau permettant de réaliser la fonction allouée au signal. On choisit de façon arbitraire le niveau bas (L) comme étant le niveau actif. On dit alors que le signal est actif. Si le signal est sur l'autre niveau (H) ont dit que le signal est inactif. De même on définit un front actif comme étant le front, ou la transition, d'un signal qui déclenche la fonction allouée au signal.

Dans la description qui suit on choisit de façon arbitraire le front montant comme front actif du signal d'horloge. Par simplification on dit qu'un signal est reçu lorsque ce signal est reçu à un niveau actif, on dit qu'un signal est émis lorsqu'il est émis à un niveau actif, on dit qu'un signal n'est pas reçu lorsqu'il est reçu à un niveau inactif et on dit qu'il n'est pas émis ou que l'émission du signal est arrêtée lorsqu'il est émis au niveau inactif.

La première partie PART1 comprend une entrée 11A (entrée de réinitialisation) recevant un signal de réinitialisation RST1 (« reset signal » en anglais). On considère que ce signal de réinitialisation RST1 a pour niveau haut 3,0V et pour niveau bas 0V. L'entrée de réinitialisation 11A est généralement reliée électriquement à un dispositif tiers (non représenté sur la figure 1) et reçoit le signal de réinitialisation RST1 de ce dispositif tiers. Ce dispositif tiers est par exemple un bouton poussoir utilisé pour la réinitialisation du circuit intégré CINT ou un autre circuit « maitre » utilisé pour l'émission du signal de réinitialisation RST1.

Classiquement il peut s'agir d'un simple bouton poussoir utilisé pour la remise à 0 d'urgence ou ce signal peut être pilote par un autre circuit « maitre » dans l'application.

La première partie PART1 comprend une sortie 21A configurée pour émettre un signal d'activation ACTIV1, décrit ci-après, vers la deuxième partie PART2.

La première partie PART1 comprend une sortie 21B configurée pour émettre un signal de réinitialisation répliqué RST2, décrit ci-après, vers la deuxième partie PART2. On considère que ce signal de réinitialisation répliqué RST2 a pour niveau haut 0,9V et pour niveau bas 0V, lorsque la deuxième partie PART2 est mode de fonctionnement actif. On considère que ce signal de réinitialisation répliqué RST2 a pour niveau haut 0,66V et pour niveau bas 0V, lorsque la deuxième partie PART2 est mode de fonctionnement veille.

Généralement la réinitialisation est réalisée lorsque le signal de réinitialisation RST1 présente un niveau bas (L), le niveau actif du signal de réinitialisation est donc le niveau bas.

La première partie PART1 comprend une entrée 11B configurée pour recevoir un signal de dépassement DEPAS, décrit ci-après, de la deuxième partie PART2.

La première partie PART1 comprend un module d'activation ACTIV configuré pour activer la deuxième partie PART2. Le module d'activation ACTIV comprend une entrée 12 reliée électriquement à l'entrée de réinitialisation 11 et une sortie 22 reliée à la sortie 21A de la première partie PART1 pour fournir le signal d'activation ACTIV1 à la deuxième partie PART2. Le module d'activation ACTIV est alors configuré pour activer la deuxième partie PART2 du circuit intégré CINT lorsque le signal de réinitialisation présente un niveau bas par envoi du signal d'activation ACTIV1.

Le module d'activation ACTIV peut aussi être configuré pour commander l'augmentation d'une tension électrique alimentant la deuxième partie PART2 lorsque le signal de réinitialisation RST1 présente un niveau bas.

La première partie PART1 comprend en outre un module d'émission EMI configuré pour émettre le signal de réinitialisation répliqué RST2. Le module d'émission EMI comprend une entrée 13A (entrée de réinitialisation) couplée à l'entrée 11A pour recevoir le signal RST1. Le module d'émission EMI comprend une entrée 13B (entrée de dépassement) couplée à l'entrée 11B, pour recevoir le signal de dépassement DEPAS de la deuxième partie PART2. Le module d'émission EMI comprend une sortie 23, reliée à la sortie 21B de la première partie PART1, émettant le signal de réinitialisation répliqué RST2.

Le module d'émission EMI est configuré pour émettre le signal de réinitialisation répliqué RST2 au niveau bas (niveau actif) à la réception du signal de réinitialisation RST1 et pour émettre le signal de réinitialisation répliqué RST2 au niveau haut (niveau inactif) à la réception du signal de dépassement DEPAS.

La deuxième partie PART2 comprend une horloge CLK, un module de détermination DET et un module de traitement UNIT de type processeur.

La deuxième partie PART2 comprend une entrée 14A (entrée d'activation) pour recevoir le signal d'activation ACTIV1 et une entrée 14B (entrée de réinitialisation) pour recevoir le signal de réinitialisation répliqué RST2. La deuxième partie PART2 comprend une sortie 24 par laquelle est émis le signal de dépassement DEPAS. La sortie 24 est reliée à l'entrée 11B de la première partie PART1, reliée à l'entrée 13B du module d'émission EMI, pour permettre la réception du signal dépassement DEPAS par le module d'émission EMI.

Le module de traitement UNIT comprend une entrée 17 (entrée de réinitialisation). L'entrée 17 est reliée à l'entrée 14B de la deuxième partie PART2, reliée à la sortie 21B de la première partie PART1, reliée à la sortie 23 du module d'émission EMI, pour recevoir le signal de réinitialisation répliqué RST2. Le module de traitement UNIT de la deuxième partie PART2 est alors configuré pour être réinitialisé lorsque le signal de réinitialisation répliqué RST2 est de niveau bas (niveau actif).

L'horloge CLK comprend une entrée 15 reliée à l'entrée 14A de la deuxième partie PART2 recevant le signal d'activation ACTIV1 de la première partie PART1 et une sortie 25 sur laquelle elle émet un signal d'horloge CLK. Le signal d'horloge CLK est un signal électrique oscillant, qui rythme les actions de la deuxième partie PART2 du circuit.

Généralement le signal électrique oscillant est de type créneau et présente une succession de fronts montants puis descendants. Une période du signal électrique oscillant est appelée cycle d'horloge. L'horloge CLOCK est éteinte lorsque la deuxième partie PART2 est en veille et n'émet pas le signal d'horloge CLK. L'horloge CLOCK est allumée lorsque la deuxième partie PART2 est active. Lorsque l'horloge CLOCK reçoit sur son entrée 15 le signal d'activation ACTIV1 elle émet le signal d'horloge CLK.

Le module de détermination DET comprend une entrée 16 et une sortie 26. Il reçoit le signal d'horloge CLK sur son entrée 16 et est configuré pour compter un nombre de fronts (montants ou descendants) du signal d'horloge CLK. Le temps écoulé dépasse le seuil temporel lorsque le nombre de fronts dépasse un seuil de fronts compris généralement de deux fronts.

Le module de détermination DET détermine ainsi qu'un temps écoulé depuis l'activation de la deuxième partie PART2 dépasse un seuil temporel et émet le signal de dépassement DEPAS sur sa sortie 26 suite à ce dépassement.

Le module de détermination DET est relié électriquement à la première partie PART1. Plus particulièrement la sortie 26 du module de détermination DET est reliée électriquement à une sortie 24 de la deuxième partie PART2, reliée à une entrée 11B de la première partie PART1, pour transmettre au module d'émission EMI le signal de dépassement DEPAS.

En conséquence, lorsque le module d'émission EMI reçoit le signal de dépassement DEPAS, le module d'émission EMI arrête l'émission du signal de réinitialisation répliqué RST2 en passant le niveau de ce signal à un niveau haut (niveau inactif). On considère généralement que le signal de dépassement DEPAS est reçu lorsque le signal de dépassement présente un niveau haut.

La deuxième partie PART2 peut aussi comporter un autre circuit interne (non représenté sur la figure 1) relié à l'entrée 14A et configuré pour recevoir le signal d'activation ACTIV1.

La figure 2 représente de manière plus détaillée le circuit intégré CINT.

Comme décrit en relation avec la figure 1, le circuit intégré CINT comprend une première partie PART1, une deuxième partie PART2, et des modules ACTIV, EMI, DET, CLOCK et UNIT.

Le module d'émission EMI comprend une porte logique G de type « et logique » et une bascule BASC.

La bascule BASC est un circuit logique. La bascule BASC comprend une entrée 13F (entrée d'horloge) reliée à l'entrée 13A du module d'émission EMI, reliée à l'entrée 11 de la première partie PART1, pour recevoir le signal de réinitialisation RST1. La bascule BASC comprend une entrée 13G (entrée d'effacement) reliée à l'entrée 13B du module d'émission EMI, reliée à l'entrée 11B de la première partie PART1, pour recevoir le signal de dépassement DEPAS. La bascule BASC comprend une entrée 13E (entrée de données) pour recevoir un signal à l'état bas L. La bascule BASC comprend enfin une sortie 23B pour fournir un signal d'état ETAT.

Le signal d'état ETAT varie suite à la réception d'un front descendant du signal de réinitialisation RST1 (reçu sur l'entrée d'horloge de la bascule). Au moment du front descendant le niveau du signal d'état ETAT prend le niveau du signal reçu sur l'entrée de données. Ensuite le niveau du signal d'état ETAT n'est pas modifié tant qu'il n'y a pas de nouveau un front descendant du signal de réinitialisation RST1. L'entrée de données est à un niveau bas, donc suite à l'apparition d'un front descendant sur le signal de l'entrée d'horloge, le signal d'état ETAT passe à un niveau bas. L'entrée 13G d'effacement permet l'effacement de la bascule BASC. Lorsqu'un signal de niveau bas est appliqué sur l'entrée d'effacement 13G de la bascule BASC le signal émis sur la sortie 23B de la bascule BASC est remis à un niveau haut.

On considère que lorsque la sortie 23B de la bascule BASC émet un signal de niveau bas L, la bascule BASC est dans un état stocké et lorsque la sortie 23B de la bascule BASC émet un signal de niveau haut H, la bascule BASC est dans un état effacé.

La porte logique G comprend une première entrée 13C, reliée à l'entrée 13A du module d'émission EMI, pour recevoir le signal de réinitialisation RST1. La porte logique G comprend une deuxième entrée 13D reliée à la sortie 23B de la bascule BASC. La porte logique G comprend une sortie 23A reliée à la sortie 23 du module d'émission EMI, pour émettre le signal de réinitialisation répliqué RST2.

Le signal de réinitialisation répliquée RST2 émis sur la sortie 23A de la porte logique G est à un niveau haut tant que la première entrée 13C et la deuxième entrée 13D reçoivent un signal de niveau haut. Le signal de réinitialisation répliqué RST2 émis sur la sortie 23A est à un niveau bas si la première entrée 13C ou la deuxième entrée 13D reçoivent un signal de niveau bas.

Ainsi, en considérant que le niveau bas est le niveau actif, lorsque le signal de réinitialisation RST1 est actif ou le signal d'état ETAT est actif, alors le signal de réinitialisation répliqué RST2 est actif.

Dans un mode de réalisation où le niveau haut est le niveau actif pour le signal de réinitialisation RST1, la porte logique G est une porte de type « ou logique » afin que, lorsque le signal de réinitialisation RST1 est actif (niveau haut) ou le signal d'état ETAT est actif (niveau haut), alors le signal de réinitialisation répliqué RST2 soit actif (niveau haut).

Le module de détermination DET comprend une première bascule BASC1 et une deuxième bascule BASC2.

La première bascule BASC1 est un circuit logique. La première bascule BASC1 comprend une entrée 16A (entrée d'horloge) reliée à l'entrée 16 du module de détermination DET, reliée à la sortie 25 de l'horloge CLOCK, pour recevoir le signal d'horloge CLK. La première bascule BASC1 comprend une entrée 16B (entrée de données) recevant un signal de niveau haut (donc un signal inactif). La première bascule BASC1 comprend une sortie 26A pour émettre un signal de sortie intermédiaire.

La deuxième bascule BASC2 est un circuit logique. La deuxième bascule BASC2 comprend une entrée 16C (entrée d'horloge) reliée à l'entrée 16 du module de détermination DET, pour recevoir le signal d'horloge CLK. La deuxième bascule BASC2 comprend une entrée 16D (entrée de données) reliée à la sortie 26A de la première bascule BASC1 pour recevoir le signal de sortie intermédiaire. La deuxième bascule BASC2 comprend une sortie 26B reliée à la sortie 26 module de détermination DET pour émettre le signal de dépassement DEPAS.

Ainsi, suite à l'activation de la deuxième partie PART2 et au redémarrage de l'horloge CLOCK de la deuxième partie PART2, le premier front descendant apparaissant sur le signal d'horloge CLK reçu sur l'entrée 16A de la première bascule BASC1 fait passer le niveau du signal de sortie intermédiaire émis sur la sortie 26A de la première bascule BASC1 d'un niveau bas à un niveau haut. Le deuxième front descendant apparaissant sur le signal d'horloge CLK reçu sur l'entrée 16C de la deuxième bascule BASC2 fait passer le niveau du signal de dépassement DEPAS émis sur la sortie 26B de la deuxième bascule BASC2 d'un niveau bas à un niveau haut. Ce signal de dépassement DEPAS est ensuite inversé en sortie 29 de porte logique G2 pour obtenir un niveau bas sur l'entrée 13G d'effacement de la bascule BASC. La réception du signal de dépassement DEPAS de niveau bas, entraine le passage de la bascule BASC, du module d'émission EMI, dans l'état effacé. Ce passage entraine l'arrêt de l'émission du signal de réinitialisation répliqué RST2 par le module d'émission EMI.

Le circuit intégré CINT de la figure 2 diffère de celui de la figure 1 en ce que la sortie 21B de la première partie PART1 et l'entrée 14B de la deuxième partie PART2 sont sélectivement reliées ou isolées électriquement l'une de l'autre par une porte logique G1 interposée.

De même, la sortie 24 de la deuxième partie PART2 et l'entrée 11B de la première partie PART1 sont sélectivement reliées ou isolées électriquement l'une de l'autre par une porte logique G2 interposée.

La porte logique G1 est une porte de type suiveuse qui présentent une sortie sélectivement reliée ou isolée électriquement à une entrée.

La porte logique G2 est une porte de type suiveuse inverseuse qui présentent une sortie sélectivement reliée ou isolée électriquement à une entrée. De plus cette porte logique inverse le niveau du signal émis sur la sortie par rapport au signal reçu sur l'entrée. Ainsi si la porte logique G2 reçoit un signal de niveau haut H elle émet un signal de niveau bas L et si la porte logique G2 reçoit un signal de niveau bas L elle émet un signal de niveau haut H.

La porte logique G1 comprend une entrée 18A reliée à la sortie 21B de la première partie PART1 et une sortie 28 reliée à l'entrée 14B de la deuxième partie PART2. La porte logique G1 comprend une entrée 18B (entrée de commande) recevant un signal d'isolation ISO, décrit ci-après. Le signal d'isolation ISO commande la porte logique G2 afin que son entrée 18A et sa sortie 28 soient reliées ou isolées.

De même, la porte logique G2 comprend une entrée 19A reliée à la sortie 24 de la première partie PART1 et une sortie 29 reliée à l'entrée 11B de la deuxième partie PART2. La porte logique G2 comprend une entrée 19B (entrée de commande) recevant le signal d'isolation ISO. Le signal d'isolation ISO commande la porte logique G2 afin que son entrée 19A et sa sortie 29 soient reliées ou isolées.

Dans le cas où les portes logiques G1 et G2 sont présentes, le module d'activation ACTIV comprend en outre une sortie 22A (sortie d'isolation), reliée à une sortie 21C de la première partie PART1, reliées aux entrées 18B et 19B de respectivement la porte logique G1 et la porte logique G2, pour fournir le signal d'isolation ISO permettant de commander les portes logiques G1 et G2. Le signal d'isolation ISO est actif tant que la tension d'alimentation de la deuxième partie PART2 est inférieure à une valeur garantissant la fonctionnalité complète de la deuxième partie PART2, soit 0.81V. Le but est de s'assurer que tant que la tension d'alimentation de la deuxième partie PART2 est inférieure à 0.81V :
- l'entrée 14B de la deuxième partie PART2 reçoit un signal ayant un niveau statique. En effet un signal variant sur la sortie 21B de la première partie PART1 n'est pas transmis du fait de la première porte logique G1. En effet à tension inférieure à 0.81V on ne saurait pas garantir l'effet dans le domaine Part2 d'une activité dynamique sur le signal de reset, on ne sait garantir que la fonction mémoire.
- l'entrée 11B de la première partie PART1 reçoit un signal ayant un niveau statique. En effet un signal variant sur la sortie 24 de la deuxième partie PART2 n'est pas transmis du fait de la deuxième porte logique G2. La transmission d'un signal de la première partie PART1 à la deuxième partie PART2 est d'autant plus complexe à réaliser que l'écart entre les tensions d'alimentation de la première partie PART1 et la deuxième partie PART2 est élevée. En particulier on peut garantir la transmission d'un signal de la deuxième partie PART2 vers la première partie PART1 uniquement si la tension d'alimentation de la deuxième partie PART2 est supérieure à 0.81V.

Dans un mode de réalisation la porte logique G1 est configurée pour relier son entrée 18A et sa sortie 28 lorsque le signal d'isolation ISO reçu sur l'entrée de commande 18B a un niveau bas L. La porte logique G1 est configurée pour isoler son entrée 18A et sa sortie 28 lorsque le signal d'isolation ISO reçu sur l'entrée de commande 18B a un niveau haut H.

De même, la porte logique G2 est configurée pour relier son entrée 19A et sa sortie 29 lorsque le signal d'isolation ISO reçu sur l'entrée de commande 19B a un niveau bas L. La porte logique G2 est configurée pour isoler son entrée 19A et sa sortie 29 lorsque le signal d'isolation ISO reçu sur l'entrée de commande 18B a un niveau haut H.

Ainsi, lorsque le signal d'isolation ISO présente un niveau haut H, le signal de réinitialisation répliquée RST2 et le signal de dépassement DEPAS ne sont pas transmis entre la première partie PART1 et la deuxième partie PART2.

La première bascule BASC1 du module de détermination DET peut comprendre une entrée 16E (entrée d'effacement), reliée à une entrée 16G du module de détermination DET, reliée à une entrée 14C de la deuxième partie PART 2, reliée à la sortie 21C de la première partie PART1, pour recevoir le signal d'isolation ISO.

De même la deuxième bascule BASC2 peut comprendre une entre 16F (entrée d'effacement), reliée à l'entrée 16G du module de détermination DET, pour recevoir le signal d'isolation ISO.

La réception d'un signal d'isolation ISO de niveau haut sur l'entrée 16E de la première bascule BASC1 entraine l'effacement de la première bascule BASC1 et le passage à un niveau bas du signal émis sur la sortie 26A de la première bascule BASC1. De même, la réception d'un signal d'isolation ISO de niveau haut sur l'entrée 16F de la deuxième bascule BASC2 entraine l'effacement de la deuxième bascule BASC2 et le passage à un niveau bas du signal émis sur la sortie 26B de la deuxième bascule BASC2.

Ainsi suite à l'émission d'un signal d'isolation de niveau haut, commandant l'arrêt de l'isolation entre la première partie PART1 et la deuxième partie PART2, les bascules BASC1 et BASC2 du module de détermination DET sont remises à zéro en prévision d'un futur cycle de réception d'un signal de réinitialisation répliqué RST2.

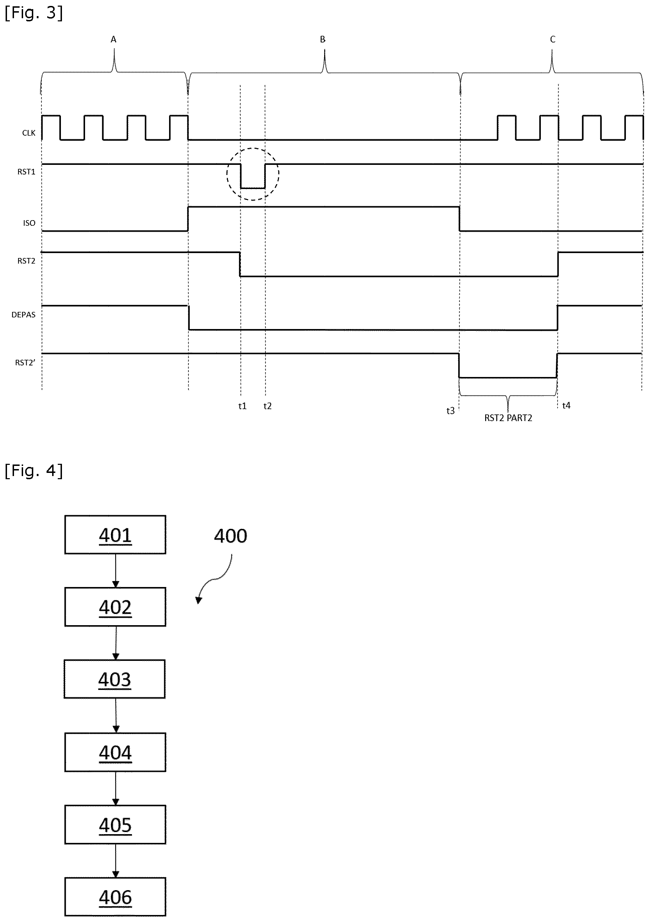

La figure 3 représente un diagramme temporel des différents signaux échangés entre les différents éléments du circuit intégré CINT décrit sur la figure 2.

Le diagramme est divisé en trois sections (de gauche à droite), une section A dans laquelle la deuxième partie PART2 est active, une section B dans laquelle la deuxième partie PART2 est en veille, et une section C dans laquelle la deuxième partie PART2 est réactivée.

En partant du haut, les signaux représentés sont les suivants :
- Le signal de l'horloge CLK de la deuxième partie PART2, ce signal d'horloge CLK est d'abord actif (section A), ensuite ce signal est inactif (section B), enfin ce signal redevient actif (section C) suite à la réactivation de la deuxième partie PART2.
- Le signal de réinitialisation RST1, ce signal est reçu entre deux instants temporels t1 et t2 à un moment où la deuxième partie PART2 est inactive (section B). Entre ces deux instants temporels la première partie PART1 est isolée de la deuxième partie PART2, la deuxième partie PART2 est en veille et la durée du signal de réinitialisation RST1 est inférieure à la durée nécessaire à la réactivation de la deuxième partie PART2. Ainsi donc la deuxième partie PART2 ne peut pas être réinitialisée en utilisant ce signal de réinitialisation RST1.

- Le signal d'isolation ISO, ce signal est mis à l'état haut H par le module d'activation ACTIV lorsque la deuxième partie PART2 est en veille (section B), afin d'isoler électriquement la première partie PART1 et la deuxième partie PART2.
- Le signal de réinitialisation répliqué RST2, ce signal est émis par le module d'émission EMI suite à la réception du signal de réinitialisation RST1 (à partir de l'instant temporel t1) et jusqu'à ce que deux fronts de l'horloge de la deuxième partie PART2 aient été reçus (jusqu'à l'instant temporel t4). Ainsi le signal de réinitialisation répliqué RST2 est émis, dans l'intervalle temporel compris entre les instants temporels t1 et t4 afin de permettre ; l'activation de la deuxième partie PART2 (commençant à l'instant temporel t3) et la réception du signal réinitialisation répliqué RST2 par la deuxième partie PART2 lorsqu'elle est réactivée.
- Le signal de dépassement DEPAS, ce signal est émis lorsque deux fronts de l'horloge de la deuxième partie PART2 ont été reçus. Suite à la réception de ce signal de dépassement, à l'instant temporel t4, le module d'émission EMI stoppe l'émission du signal de réinitialisation répliqué.
- Le signal de réinitialisation répliqué RST2' tel que reçut par la deuxième partie PART2. La porte logique G1 est en mode isolé jusqu'à l'instant temporel t3 marquant le début de l'activation de la deuxième partie PART2. Ainsi le signal de réinitialisation répliquée RST2 émis sur la sortie 21B de la première partie PART1 n'est pas reçu, du fait de l'isolation de la porte logique G1, sur l'entrée 14B de la deuxième partie PART2, durant l'intervalle temporel compris entre t1 et t3. Ce signal de réinitialisation répliqué RST2 est reçu par la deuxième partie PART2 à partir de l'instant temporel t3 (marquant la fin de l'isolation entre la première partie PART1 et la deuxième partie PART2) et jusqu'à l'instant temporel t4 (marquant la fin de l'émission du signal de réinitialisation répliqué RST2).

La figure 4 représente un procédé 400 de réinitialisation selon un aspect de l'invention.

Plus particulièrement, le procédé 400 est un procédé de réinitialisation de la deuxième partie PART2 du circuit intégré CINT par la première partie PART1 du circuit intégré CINT.

Ce procédé comprend les étapes 401 à 406 suivantes :
- Etape 401 - la réception du signal de réinitialisation RST1 par la première partie PART1,
- Etape 402 - l'activation de la deuxième partie PART2,
- Etape 403 - la connexion électrique entre la première partie PART1 et la deuxième partie PART2,
- Etape 404 - l'émission d'un signal de réinitialisation répliqué RST2 par la première partie PART1 vers la deuxième partie PART2,
- Etape 405 - la détermination qu'un temps écoulé depuis l'activation de la deuxième partie PART2 a dépassé un seuil, et
- Etape 406 - l'arrêt de l'émission du signal de réinitialisation répliqué RST2 lorsque le temps écoulé depuis l'activation de la deuxième partie PART2 a dépassé le seuil.

Si la première partie PART1, et la deuxième partie PART2 sont reliées électriquement de manière permanente entre elles, l'étape de connexion 403 n'est pas nécessaire.

## Revendications

1. Circuit intégré (CINT) comprenant une première partie (PART1) et une deuxième partie (PART2) ;
la première partie (PART1) comprenant :
- une entrée de réinitialisation (11A) configurée pour recevoir un signal de réinitialisation (RST1),
- un module d'activation (ACTIV) relié à l'entrée de réinitialisation (11A), le module d'activation (ACTIV) étant configuré pour activer la deuxième partie (PART2) à la réception du signal de réinitialisation, et
- un module d'émission (EMI) configuré pour émettre un signal de réinitialisation répliqué (RST2);
la deuxième partie (PART2) pouvant être sélectivement activée ou désactivée, la deuxième partie (PART2) comprenant une entrée de réinitialisation (14B) configurée pour recevoir le signal de réinitialisation répliqué (RST2) du module d'émission (EMI) ;
le circuit intégré (CINT) étant tel que le module d'émission (EMI) est configuré pour émettre le signal de réinitialisation répliqué (RST2) à la réception du signal de réinitialisation (RST1) ;
**caractérisé en ce que** :
la deuxième partie (PART2) comprend en outre un module de détermination (DET) configuré pour déterminer qu'un temps écoulé à partir de l'activation de la deuxième partie du circuit dépasse un seuil et pour émettre un signal de dépassement lorsque le seuil est dépassé ; et
le circuit intégré (CINT) est tel que le module d'émission (EMI) est configuré pour arrêter l'émission du signal de réinitialisation répliqué (RST2) lorsque le signal de dépassement est actif.

2. Circuit intégré selon la revendication 1, dans lequel :
le module d'émission (EMI) comprend une bascule (BASC) ;
la bascule (BASC) est configurée pour être sélectivement dans un état stocké ou dans un état effacé,
la bascule (BASC) comprend :
- une entrée d'horloge (13F), reliée à l'entrée de réinitialisation (11A) de la première partie (PART1),
- une entrée de données (13E) recevant un signal actif,
- une entrée d'effacement (13G), reliée à une sortie (26) du module de détermination (DET) ;
le module de détermination (DET) est configuré pour émettre sur sa sortie (26) le signal de dépassement (DEPAS) lorsque le seuil est dépassé ;
la bascule (BASC) est configurée pour passer dans l'état stocké, à la réception d'un front du signal du réinitialisation (RST) ;
une sortie (23B) de la bascule (BASC) est configurée pour émettre un signal d'état (ETAT) actif lorsque la bascule (BASC) est dans l'état stockée ;
la bascule (BASC) est configurée pour passer dans l'état effacé, lorsque le signal de dépassement (DEPAS) est actif ; et
la sortie (23B) de la bascule (BASC) est configurée pour émettre un signal d'état (ETAT) inactif lorsque la bascule (BASC) est dans l'état effacé.

3. Circuit intégré selon la revendication 2, dans lequel :
le module d'émission (EMI) comprend une porte logique (G) ;
la porte logique (G) comprend :
- une première entrée (13D) configurée pour recevoir le signal d'état (ETAT) de la sortie (23B) de la bascule (BASC),
- une deuxième entrée (13C) configurée pour recevoir le signal de réinitialisation (RST),
- une sortie (23A) reliée à la sortie (23) du module d'émission (EMI) et configurée pour émettre le signal de réinitialisation répliqué (RST2) ; et
la porte logique (G) est configurée pour que le signal de réinitialisation répliqué (RST2) soit actif si le signal d'état (ETAT) est actif ou si le signal de réinitialisation (RST) est actif.

4. Circuit intégré selon l'une des revendications 1 à 3, dans lequel :
la deuxième partie (PART2) comprend une horloge (CLOCK) configurée pour émettre un signal d'horloge (CLK) lorsque la deuxième partie (PART2) est active ;
le module de détermination (DET) comprend une première bascule (BASC1) et une deuxième bascule (BASC2) ;
la première bascule (BASC1) comprend :
- une entrée d'horloge (16a) configurée pour recevoir le signal d'horloge (CLK),
- une entrée de données (16B) configurée pour recevoir un signal inactif,
- une sortie (26A) configurée pour émettre un signal de sortie intermédiaire ;
la première bascule (BASC1) est configurée pour que, suite à un premier front du signal d'horloge (CLK), le signal de sortie intermédiaire passe dans un état actif ;
la deuxième bascule (BASC2) comprend :
- une entrée d'horloge (16C) configurée pour recevoir le signal d'horloge (CLK),
- une entrée de données (16D) reliée à la sortie (26A) de la première bascule (BASC1),
- une sortie (26B), reliée à la sortie (26) du module de détermination (DET) et configurée pour émettre le signal de dépassement (DEPAS) ; et
la deuxième bascule (BASC2) est configurée pour que, suite à un deuxième front du signal d'horloge (CLK) postérieur au premier front, le signal de dépassement (DEPAS) passe dans un état actif.

5. Circuit intégré selon l'une des revendications 1 à 4, comprenant en outre :
une première porte logique (G1) comprenant :
- une entrée (18A) reliée à la sortie (23) du module d'émission (EMI) de la première partie (PART1),
- une sortie (28) reliée à l'entrée de réinitialisation (14B) de la deuxième partie (PART2),
- une entrée de commande (18B) reliée à une sortie d'isolation (22A) du module d'activation (ACTIV) ; et
une deuxième porte logique (G2) comprenant :
- une entrée (19A) reliée à la sortie de dépassement (26) du module de détermination (DET),
- une sortie (29) reliée à une entrée de dépassement (13B) du module d'émission (EMI) de la première partie (PART1),
- une entrée de commande (19B) reliée à la sortie d'isolation (22A) du module d'activation (ACTIV) ;
le module d'activation (ACTIV) étant configuré pour émettre un signal d'isolation (ISO) sur sa sortie d'isolation (22A) ;
la première porte logique (G1) étant configurée pour être passante à la réception du signal d'isolation (ISO) sur son entrée de commande (18B) ; et
la deuxième porte logique (G2) étant configurée pour être passante à la réception d'un signal d'isolation (ISO) sur son entrée de commande (19B).

6. Procédé de réinitialisation d'une deuxième partie (PART2) d'un circuit intégré (CINT) par une première partie (PART1) du circuit intégré (CINT), la deuxième partie (PART2) pouvant être sélectivement activée ou désactivée ;
le procédé comprenant les étapes suivantes :
- réception (401) d'un signal de réinitialisation (RST) par la première partie (PART1),
- activation (402) de la deuxième partie (PART2) par la première partie (PART1),
- émission (404) d'un signal de réinitialisation répliqué (RST2) par la première partie (PART1) vers la deuxième partie (PART2),
le procédé étant **caractérisé en ce qu'**il comprend en outre les étapes suivantes :
- détermination (405) par la deuxième partie (PART2) qu'un temps écoulé depuis l'activation de la deuxième partie (PART2) a dépassé un seuil, et
- arrêt (406) de l'émission du signal de réinitialisation répliqué (RST2) lorsque le temps écoulé depuis l'activation de la deuxième partie (PART2) a dépassé le seuil.

7. Procédé de réinitialisation selon la revendication 6 comprenant en outre une
étape de connexion (403) électrique entre la première partie (PART1) et la deuxième partie (PART2),
l'étape de connexion (403) étant réalisée entre l'étape d'activation (402) et l'étape d'émission (404).

8. Produit programme d'ordinateur comprenant des instructions de code de programme qui, lorsqu'elles sont exécutées par un circuit intégré (CINT), permettent la mise en oeuvre du procédé de réinitialisation selon la revendication 6 ou 7.

## Patentansprüche

1. Integrierte Schaltung (CINT), die einen ersten Teil (PART1) und einen zweiten Teil (PART2) aufweist;
wobei der erste Teil (PART1) folgendes aufweist:
- einen Rücksetzeingang (11A), der zum Empfang eines Rücksetzsignals (RST1) eingerichtet ist,
- ein Aktivierungsmodul (ACTIV), das mit dem Rücksetzeingang (11A) verbunden ist, wobei das Aktivierungsmodul (ACTIV) eingerichtet ist, den zweiten Teil (PART2) bei Empfang des Rücksetzsignals zu aktivieren, und
- ein Emissionsmodul (EMI), das eingerichtet ist, um ein repliziertes Rücksetzsignal (RST2) zu senden;
wobei der zweite Teil (PART2) selektiv aktiviert oder deaktiviert werden kann, wobei der zweite Teil (PART2) einen Rücksetzeingang (14B) aufweist, der eingerichtet ist, um das replizierte Rücksetzsignal (RST2) des Emissionsmoduls (EMI) zu empfangen;
wobei die integrierte Schaltung (CINT) so beschaffen ist, dass das Emissionsmodul (EMI) eingerichtet ist, um das replizierte Rücksetzsignal (RST2) bei Empfang des Rücksetzsignals (RST1) auszusenden;
**dadurch gekennzeichnet, dass**:
der zweite Teil (PART2) ferner ein Bestimmungsmodul (DET) aufweist, das eingerichtet ist, zu bestimmen, dass eine verstrichene Zeit ab der Aktivierung des zweiten Teils der Schaltung einen Schwellenwert überschreitet, und ein Überschreitungssignal zu emittieren, wenn der Schwellenwert überschritten wird; und
die integrierte Schaltung (CINT) so beschaffen ist, dass das Emissionsmodul (EMI) eingerichtet ist, die Emission des replizierten Rücksetzsignals (RST2) zu stoppen, wenn das Überschreitungssignal aktiv ist.

2. Integrierte Schaltung nach Anspruch 1, wobei:
das Emissionsmodul (EMI) ein Flip-Flop (BASC) aufweist;
das Flip-Flop (BASC) eingerichtet ist, um sich selektiv in einem gespeichert-Zustand oder in einem gelöscht-Zustand zu befinden,
das Flip-Flop (BASC) folgendes aufweist:
- einen Takteingang (13F), der mit dem Rücksetzeingang (11A) des ersten Teils (PART1) gekoppelt ist,
- einen Dateneingang (13E), der ein Aktivsignal empfängt,
- einen Löscheingang (13G), der mit einem Ausgang (26) des Bestimmungsmoduls (DET) verbunden ist;
das Bestimmungsmodul (DET) eingerichtet ist, um an seinem Ausgang (26) das Überschreitungssignal (DEPAS) auszugeben, wenn der Schwellenwert überschritten wird;
das Flip-Flop (BASC) eingerichtet ist, um bei Empfang einer Flanke des Rücksetzsignals (RST) in den gespeichert-Zustand zu wechseln;
ein Ausgang (23B) des Flipflops (BASC) eingerichtet ist, um ein aktiv-Zustandssignal (ETAT) zu emittieren, wenn sich das Flipflop (BASC) in dem gespeichert-Zustand befindet;
das Flip-Flop (BASC) eingerichtet ist, um in den gelöscht-Zustand zu wechseln, wenn das Überschreitungssignal (DEPAS) aktiv ist; und
der Ausgang (23B) des Flipflops (BASC) eingerichtet ist, um ein Inaktiv-Zustandssignal (ETAT) auszugeben, wenn sich das Flipflop (BASC) im gelöscht-Zustand befindet.

3. Integrierte Schaltung nach Anspruch 2, wobei:
das Emissionsmodul (EMI) ein logisches Gatter (G) aufweist;
das logische Gatter (G) folgendes aufweist:
- einen ersten Eingang (13D), der eingerichtet ist, um das Zustandssignal (ETAT) des Ausgangs (23B) des Flip-Flops (BASC) zu empfangen,
- einen zweiten Eingang (13C), der eingerichtet ist, um das Rücksetzsignal (RST) zu empfangen,
- einen Ausgang (23A), der mit dem Ausgang (23) des Emissionsmoduls (EMI) gekoppelt und eingerichtet ist, um das replizierte Rücksetzsignal (RST2) auszugeben; und
das Logikgatter (G) eingerichtet ist, so dass das replizierte Rücksetzsignal (RST2) aktiv ist, wenn das Zustandssignal (ETAT) aktiv ist oder wenn das Rücksetzsignal (RST) aktiv ist.

4. Integrierte Schaltung nach einem der Ansprüche 1 bis 3, wobei:
der zweite Teil (PART2) einen Taktgeber (CLOCK) aufweist, der eingerichtet ist, um ein Taktsignal (CLK) auszugeben, wenn der zweite Teil (PART2) aktiv ist;
das Bestimmungsmodul (DET) ein erstes Flip-Flop (BASC1) und ein zweites Flip-Flop (BASC2) aufweist;
das erste Flip-Flop (BASC1) folgendes aufweist:
- einen Takteingang (16a), der eingerichtet ist, um das Taktsignal (CLK) zu empfangen,
- einen Dateneingang (16B), der eingerichtet ist, um ein inaktiv-Signal zu empfangen,
- einen Ausgang (26A), der eingerichtet ist, um ein Zwischenausgangssignal auszugeben;
das erste Flipflop (BASC1) eingerichtet ist, so dass nach einer ersten Flanke des Taktsignals (CLK) das Zwischenausgangssignal in einen Aktivzustand schaltet;
das zweite Flipflop (BASC2) folgendes aufweist:
- einen Takteingang (16C), der eingerichtet ist, um das Taktsignal (CLK) zu empfangen,
- einen Dateneingang (16D), der mit dem Ausgang (26A) des ersten Flipflops (BASC1) gekoppelt ist,
- einen Ausgang (26B), der mit dem Ausgang (26) des Bestimmungsmoduls (DET) gekoppelt und eingerichtet ist, um das Überschreitungssignal (DEPAS) auszugeben; und
das zweite Flipflop (BASC2) eingerichtet ist, so dass nach einer zweiten Flanke des Taktsignals (CLK), die auf die erste Flanke folgt, das Überschreitungssignal (DEPAS) in einen Aktivzustand übergeht.

5. Integrierte Schaltung nach einem der Ansprüche 1 bis 4, die ferner folgendes aufweist:
ein erstes logisches Gatter (G1), das folgendes aufweist:
- einen Eingang (18A), der mit dem Ausgang (23) des Emissionsmoduls (EMI) des ersten Teils (PART1) gekoppelt ist,
- einen Ausgang (28), der mit dem Rücksetzeingang (14B) des zweiten Teils (PART2) gekoppelt ist,
- einen Steuereingang (18B), der mit einem Isolationsausgang (22A) des Aktivierungsmoduls (ACTIV) gekoppelt ist; und
ein zweites Logikgatter (G2), das folgendes aufweist:
- einen Eingang (19A), der mit dem Überschreitungsausgang (26) des Bestimmungsmoduls (DET) gekoppelt ist,
- einen Ausgang (29), der mit einem Überschreitungseingang (13B) des Emissionsmoduls (EMI) des ersten Teils (PART1) verbunden ist,
- einen Steuereingang (19B), der mit dem Isolationsausgang (22A) des Aktivierungsmoduls (ACTIV) verbunden ist;
wobei das Aktivierungsmodul (ACTIV) eingerichtet ist, um ein Isolationssignal (ISO) an seinem Isolationsausgang (22A) auszugeben;
das erste Logikgatter (G1) eingerichtet ist, um bei Empfang des Isolationssignals (ISO) an seinem Steuereingang (18B) AN zu sein; und
das zweite Logikgatter (G2) eingerichtet ist, um bei Empfang eines Isolationssignals (ISO) an seinem Steuereingang (19B) AN zu sein.

6. Verfahren zum Zurücksetzen eines zweiten Teils (PART2) einer integrierten Schaltung (CINT) durch einen ersten Teil (PART1) der integrierten Schaltung (CINT), wobei der zweite Teil (PART2) selektiv aktiviert oder deaktiviert werden kann;
wobei das Verfahren die folgenden Schritte aufweist:
- Empfang (401) eines Rücksetzsignals (RST) durch den ersten Teil (PART1),
- Aktivierung (402) des zweiten Teils (PART2) durch den ersten Teil (PART1),
- Emission (404) eines replizierten Rücksetzsignals (RST2) durch den ersten Teil (PART1) an den zweiten Teil (PART2),
wobei das Verfahren **dadurch gekennzeichnet ist, dass** es ferner die folgenden Schritte aufweist:
- Feststellung (405) durch den zweiten Teil (PART2), dass eine verstrichene Zeit seit der Aktivierung des zweiten Teils (PART2) einen Schwellenwert überschritten hat, und
- Unterbrechung (406) der Emission des replizierten Rücksetzsignals (RST2), wenn die verstrichene Zeit seit der Aktivierung des zweiten Teils (PART2) den Schwellenwert überschritten hat.

7. Verfahren zum Zurücksetzen nach Anspruch 6, das ferner einen Schritt der elektrischen Verbindung (403) zwischen dem ersten Teil (PART1) und dem zweiten Teil (PART2) aufweist,
wobei der Verbindungsschritt (403) zwischen dem Aktivierungsschritt (402) und dem Emissionsschritt (404) ausgeführt wird.

8. Computerprogrammprodukt, das Programmcode-Anweisungen aufweist, die, wenn sie von einer integrierten Schaltung (CINT) ausgeführt werden, die Durchführung des Verfahrens zum Zurücksetzen nach Anspruch 6 oder 7 ermöglichen.

## Claims

1. Integrated circuit (CINT) comprising a first portion (PART1) and a second portion (PART2);
the first portion (PART1) comprising:
- a reset input (11A) configured to receive a reset signal (RST1),
- an activation module (ACTIV) connected to the reset input (11A), the activation module (ACTIV) being configured to activate the second portion (PART2) upon reception of the reset signal, and
- an emissions module (EMI) configured to emit a replicated reset signal (RST2);
the second portion (PART2) being able to be selectively activated or deactivated, the second portion (PART2) comprising a reset input (14B) configured to receive the replicated reset signal (RST2) of the emissions module (EMI);
the integrated circuit (CINT) being such that the emissions module (EMI) is configured to emit the replicated reset signal (RST2) upon reception of the reset signal (RST1);
**characterized in that**:
the second portion (PART2) further comprises a determination module (DET) configured to determine that an elapsed time starting from the activation of the second portion of the circuit oversteps a threshold and to emit an overstepping signal when the threshold is overstepped; and
the integrated circuit (CINT) is such that the emissions module (EMI) is configured to stop the emission of the replicated reset signal (RST2) when overstepping signal is active.

2. Integrated circuit according to claim 1, wherein:
the emissions module (EMI) comprises a flip-flop (BASC);
the flip-flop (BASC) is configured to be selectively in a stored state or in an erased state,
the flip-flop (BASC) comprises:
- a clock input (13F), coupled to the reset input (11A) of the first portion (PART1),
- a data input (13E) receiving an active signal,
- an erasure input (13G), coupled to an output (26) of the determination module (DET);
the determination module (DET) is configured to emit on its output (26) the overstepping signal (DEPAS) when the threshold is overstepped;
the flip-flop (BASC) is configured to switch to the stored state, upon reception of an edge of the reset signal (RST);
an output (23B) of the flip-flop (BASC) is configured to emit an active state signal (ETAT) when the flip-flop (BASC) is in the stored state;
the flip-flop (BASC) is configured to switch to the erased state, when the overstepping signal (DEPAS) is active; and
the output (23B) of the flip-flop (BASC) is configured to emit an inactive state signal (ETAT) when the flip-flop (BASC) is in the erased state.

3. Integrated circuit according to claim 2, wherein:
the emissions module (EMI) comprises a logic gate (G);
the logic gate (G) comprises:
- a first input (13D) configured to receive the state signal (ETAT) of the output (23B) of the flip-flop (BASC),
- a second input (13C) configured to receive the reset signal (RST),
- an output (23A) coupled to the output (23) of the emissions module (EMI) and configured to emit the replicated reset signal (RST2); and
the logic gate (G) is configured so that the replicated reset signal (RST2) is active if the state signal (ETAT) is active or if the reset signal (RST) is active.

4. Integrated circuit according to one of claims 1 to 3, wherein:
the second portion (PART2) comprises a clock (CLOCK) configured to emit a clock signal (CLK) when the second portion (PART2) is active;
the determination module (DET) comprises a first flip-flop (BASC1) and a second flip-flop (BASC2);
the first flip-flop (BASC1) comprises:
- a clock input (16a) configured to receive the clock signal (CLK),
- a data input (16B) configured to receive an inactive signal,
- an output (26A) configured to emit an intermediate output signal;
the first flip-flop (BASC1) is configured so that, following a first edge of the clock signal (CLK), the intermediate output signal switches to an active state;
the second flip-flop (BASC2) comprises:
- a clock input (16C) configured to receive the clock signal (CLK),
- a data input (16D) coupled to the output (26A) of the first flip-flop (BASC1),
- an output (26B), coupled to the output (26) of the determination module (DET) and configured to emit the overstepping signal (DEPAS); and
the second flip-flop (BASC2) is configured so that, following a second edge of the clock signal (CLK) subsequent to the first edge, the overstepping signal (DEPAS) switches to an active state.

5. Integrated circuit according to one of claims 1 to 4, further comprising:
a first logic gate (G1) comprising:
- an input (18A) coupled to the output (23) of the emissions module (EMI) of the first portion (PART1),
- an output (28) coupled to the reset input (14B) of the second portion (PART2),
- a control input (18B) coupled to an isolation output (22A) of the activation module (ACTIV); and
a second logic gate (G2) comprising:
- an input (19A) coupled to the overstepping output (26) of the determination module (DET),
- an output (29) coupled to an overstepping input (13B) of the emissions module (EMI) of the first portion (PART1),
- a control input (19B) connected to the isolation output (22A) of the activation module (ACTIV);
the activation module (ACTIV) being configured to emit an isolation signal (ISO) on its isolation output (22A);
the first logic gate (G1) being configured to be ON upon reception of the isolation signal (ISO) on its control input (18B); and
the second logic gate (G2) being configured to be ON upon reception of an isolation signal (ISO) on its control input (19B).

6. Method for resetting a second portion (PART2) of an integrated circuit (CINT) by a first portion (PART1) of the integrated circuit (CINT), the second portion (PART2) being able to be selectively activated or deactivated;
the method comprising the following steps:
- reception (401) of a reset signal (RST) by the first portion (PART1),
- activation (402) of the second portion (PART2) by the first portion (PART1),
- emission (404) of a replicated reset signal (RST2) by the first portion (PART1) to the second portion (PART2),
the method being **characterized by** further comprising the following steps:
- determination (405) by the second portion (PART2) that an elapsed time since the activation of the second portion (PART2) has overstepped a threshold, and
- stoppage (406) of the emission of the replicated reset signal (RST2) when the elapsed time since the activation of the second portion (PART2) has overstepped the threshold.

7. Method for resetting according to claim 6 further comprising a step of electrical connection (403) between the first portion (PART1) and the second portion (PART2),
the connection step (403) being carried out between the activation step (402) and the emission step (404).

8. Computer program product comprising program code instructions that, when they are executed by an integrated circuit (CINT), allow for the implementation of the method for resetting according to claim 6 or 7.
